# EUROPEAN PATENT APPLICATION

(11) **EP 4 644 922 A1**
(43) Date of publication of application: **05.11.2025**
(21) Application number: 25172342.5
(22) Date of filing: 24.04.2025
(51) Int. Cl.: G01R 31/3185, G01R 31/30

(54) **CRITICAL PATH SENSITIZATION IN ELECTRONIC SYSTEMS**

(30) Priority: 29.04.2024 IN 202441033760
(71) Applicant: NXP B.V., 5656 AG Eindhoven (NL)
(72) Inventor: Narula, Deep, 5656AG Eindhoven (NL); Gupta, Akshat, 5656AG Eindhoven (NL); Khandelwal, Amitesh, 5656AG Eindhoven (NL); Zangi, Uzi, 5656AG Eindhoven (NL); Dayag, Noga, 566AG Eindhoven (NL); Atri, Himanshu, 5656AG Eindhoven (NL)
(74) Representative: Miles, John Richard

(57) **Abstract**

An electronic system, comprising a critical logic circuit, various scan chains, and a control circuit, is provided. The critical logic circuit includes a critical path. One or more scan chains of the electronic system are coupled to the critical logic circuit and are associated with sensitization of the critical path. The control circuit may receive one or more configuration datasets, where each configuration dataset includes a scan chain identifier and a test pattern. For each received configuration dataset, the control circuit may identify a scan chain, of the one or more scan chains, that is associated with the scan chain identifier, and load the identified scan chain with the test pattern. Some scan flip-flops of the loaded one or more scan chains are utilized to sensitize the critical path.

## Description

### FIELD OF USE

The present disclosure relates generally to electronic systems and, more particularly, to critical path sensitization in electronic systems.

### BACKGROUND

Electronic systems, such as integrated circuits (ICs), include various logic gates, flip-flops, registers, and other combinational and sequential elements that introduce delays in signal propagation. Typically, in an IC, some of the aforementioned elements are coupled in a chain, forming a signal path between two specific points (*e.g.,* between inputs and outputs). The maximum delay that a signal takes to propagate through the signal path is critical for the operation of the IC and is required to be within the timing requirement of the IC. Hence, such a signal path is referred to as a critical path. The IC may include multiple critical paths, and the operation of the IC is reliant on the critical paths being accurately managed (*e.g.,* delays being within the timing requirement). Failure to manage the critical path results in timing violations, where signals arrive at destinations too late or too early, thereby causing malfunctions or errors in the operation of the IC.

### BRIEF DESCRIPTION OF DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a schematic diagram of a testing environment in accordance with an embodiment of the present disclosure;
FIG. 2 illustrates a schematic block diagram of a control circuit and scan chains of the testing environment of FIG. 1 in accordance with an embodiment of the present disclosure;
FIG. 3 illustrates a schematic circuit diagram of a critical logic circuit of the testing environment of FIG. 1 in accordance with an embodiment of the present disclosure; and
FIGS. 4A and 4B, collectively, represents a flowchart that illustrates a critical path sensitization method in accordance with an embodiment of the present disclosure.

### DETAILED DESCRIPTION

The detailed description of the appended drawings is intended as a description of the embodiments of the present disclosure, and is not intended to represent the only form in which the present disclosure may be practiced. It is to be understood that the same or equivalent functions may be accomplished by different embodiments that are intended to be encompassed within the spirit and scope of the present disclosure.

### Overview:

In an electronic system, such as an integrated circuit (IC), critical paths are required to be managed (e.g., tested) to ensure optimal operations. To test a critical path, the critical path is sensitized and an output signal of the sensitized critical path is monitored to determine whether the delay of the sensitized critical path is within a tolerance limit (*e.g.,* timing faults are absent). The sensitization of a critical path ensures that an input signal propagates through all the elements of the critical path, thereby enabling accurate determination of the associated delay. To ensure that the input signal traverses exclusively through the elements of the critical path, other inputs (*e.g.,* inputs not related to the input signal) of such elements are required to be maintained at predetermined logic levels.

Conventionally, to sensitize a critical path, a side pin engineering change order (ECO) technique is utilized. In this technique, additional logic gates are included in the IC to ensure at least one input pin of all elements (*e.g.,* logic gates, flip-flops, or the like) of the critical path is tied off (*e.g.,* maintained at the predetermined logic level). The use of additional gates results in increased area and power consumption of the IC. The additional gates are typically included in various functional paths of the IC, and hence, may result in undesired changes in the timing requirement of the IC. Further, the placement of the additional gates may result in the creation of new critical paths, leading to increased design complexity and release-to-market time.

Other approaches to sensitize a critical path include the use of scan chains. In one such approach, an automatic test pattern generator (ATPG) tool and a decompressor may be utilized to configure various scan flip-flops included in the scan chains. The ATPG tool may generate a test pattern with a limited number of bits, and the decompressor may decompress the test pattern for the configuration of all scan chains. Some scan flip-flops may be coupled, directly or indirectly, to the path elements, and the configuration enables at least one input of these path elements to be maintained at the predetermined logic level. The decompression technique implemented by the decompressor is fixed, and hence, it is difficult to accurately obtain specific logic states for all the desired scan flip-flops. Consequently, all the critical paths of the IC may not be accurately sensitized. In another approach, all the scan chains of the IC may be concatenated to form a single (long) scan chain and the decompressor may be bypassed by the ATPG tool to directly load the concatenated scan chain with desired values. However, in such an approach, the concatenated scan chain is significantly long and results in significantly high run time and test time.

Additionally, some of the critical paths may not be functionally valid (*e.g.,* two inputs, having the same source, require inverting logic states). All the aforementioned techniques are incapable of determining whether a critical path is functionally valid. Instead, each technique attempts to sensitize all the critical paths, irrespective of whether the critical paths are functionally valid or invalid, leading to increased stress on the voltage-frequency relationship of the IC. For example, a functionally invalid critical path may have a comparatively higher delay, leading to lower (*e.g.,* less than required) operational frequency of the IC. The increased stress on the voltage-frequency relationship of the IC directly impacts the performance (*e.g.,* throughput) of the IC over the lifespan.

Various embodiments of the present disclosure disclose an electronic system (*e.g.,* an IC) that includes a critical path and a sensitizing circuit that may sensitize the critical path. The sensitizing circuit may include a control circuit and multiple scan chains. A test circuit, that is external to the IC, may identify one or more scan chains that are required for the sensitization of the critical path. In an example, each of the one or more scan chains may include at least one scan flip-flop that is coupled, directly or indirectly, to a critical path element. To configure the one or more scan chains with desired values, the test circuit may generate one or more configuration datasets, respectively. Each configuration dataset may include a scan chain identifier and a test pattern. The control circuit may receive the one or more configuration datasets. For each configuration dataset, the control circuit may identify, from the various scan chains, a scan chain that is associated with the scan chain identifier, and load the identified scan chain with the test pattern. Thus, the one or more scan chains are loaded with corresponding test patterns. In other words, all the desired scan flip-flops are configured to be at desired logic levels to sensitize the critical path. Consequently, the other inputs (*e.g.,* inputs not related to an input signal) of all the elements of the critical path are maintained at the predetermined logic levels and the input signal may propagate exclusively through the elements of the critical path.

Thus, in the present disclosure, the control circuit and the scan chains are utilized to sensitize the critical path. The scan chains are already present in the IC for the structural testing thereof, and the control circuit includes small-sized components such as multiplexers and a decoder. Thus, the area and power consumption of the IC of the present disclosure are significantly less than that of an IC where the side pin ECO technique is implemented. Further, the sensitization technique of the present disclosure does not include the use of additional gates placed along the functional paths. As a result, the creation of new critical paths and undesired changes in the timing requirement of the IC are avoided, leading to reduced design complexity and shorter release-to-market time.

In the present disclosure, the decompressor is bypassed, and the control circuit directly configures the relevant scan chains to the desired values based on the configuration datasets received from the test circuit. This ensures complete and accurate sensitization of all critical paths. Thus, in the present disclosure, as the complete and accurate sensitization is achieved by directly loading (*e.g.,* configuring) exclusively the relevant scan chains, concatenation of all the scan chains is not necessitated. Consequently, the run time and the test time of the sensitization technique of the present disclosure are less than that of some conventional techniques that require scan chain concatenation. In some embodiments, the scan flip-flops identified for sensitization may be re-ordered to be spread across a minimum number of scan chains to further reduce the run time and test time.

Additionally, in the present disclosure, during the identification of scan chains required for sensitization, the validity of each critical path is determined. Thus, exclusively the functionally valid critical paths are sensitized. Consequently, the stress on the voltage-frequency relationship of the IC of the present disclosure is reduced, and in turn, the performance (*e.g.,* throughput) of the IC over the lifespan is improved. Further, the sensitization technique of the present disclosure enables simultaneous and dynamic sensitization of all critical paths, thereby increasing the efficiency of the sensitization.

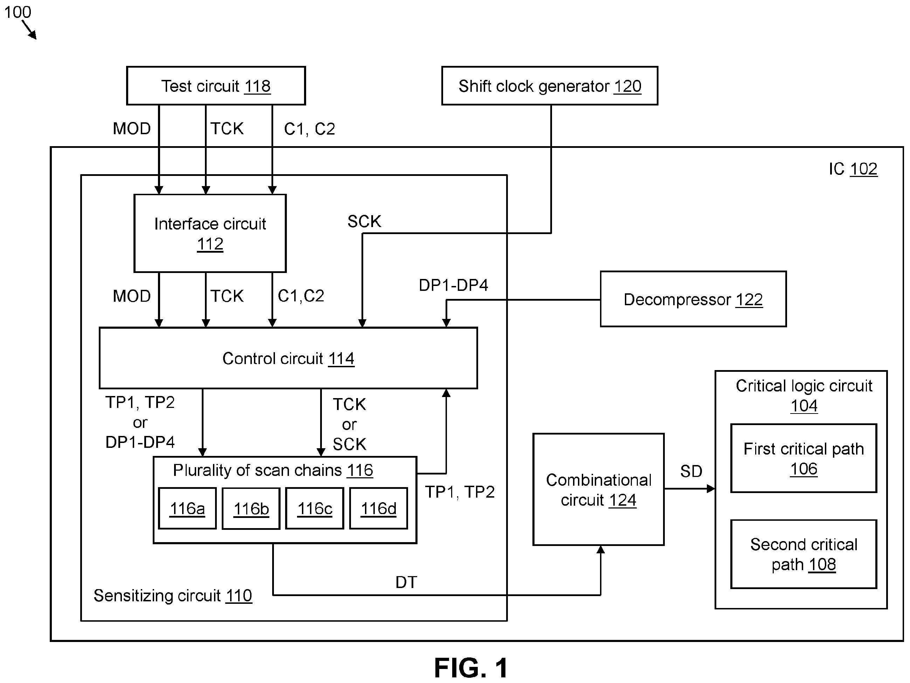

FIG. 1 illustrates a schematic diagram of a testing environment 100 in accordance with an embodiment of the present disclosure. The testing environment 100 may include an electronic system 102. The electronic system 102 may correspond to an integrated circuit (IC) and is hereinafter referred to as the "IC 102". The IC 102 may be utilized in various mobile devices, wearables, networking devices, or the like.

### IC 102:

The IC 102 may include a critical logic circuit 104. The critical logic circuit 104 may include various combinational and sequential elements (*e.g.,* logic gates, flip-flops, registers, multiplexers, or the like) that may be essential for the functionality of IC 102. Some of the elements may be coupled in a chain, forming a signal path between two points on the IC 102. Along the signal path, each element may introduce a delay. Thus, an output signal at the path destination, having propagated through the signal path, may be a delayed version of an input signal at the path source. This delay is referred to as the propagation delay. Some signal paths in the IC 102 may be timing critical, in that the delay of such signal paths may be close to the timing requirement of the IC 102. Such timing critical signal paths are referred to as critical paths.

To avoid timing violations in the IC 102, the delay of each critical path is required to be within a tolerance limit. The timing requirement of the IC 102 may be defined based on an operating frequency of the IC 102, and the tolerance limit may be a function of the timing requirement. It is thus essential to monitor the delay of each critical path of the IC 102. To monitor the delay (*e.g.,* determine whether the delay is within the tolerance limit), the IC 102 may need to be switched to a testing mode from a functional mode. In other words, determining whether the delay of each critical path is within the tolerance limit may correspond to critical path testing. The testing of a critical path includes sensitization of the critical path and monitoring of the output signal of the sensitized critical path to determine whether the delay is within the tolerance limit (*e.g.,* timing faults are absent). The sensitization of a critical path results in an input signal propagating through each element of the critical path. To ensure that the input signal traverses through all elements of the critical path, the other inputs of such elements are required to be maintained at predetermined logic levels.

The delay of the sensitized critical path may be utilized to execute various operations of the IC 102. For example, in the IC 102, adaptive dynamic voltage control (ADVC) technology may be used to achieve low operating voltages, and the optimal operating voltage of the IC 102 is a function of the delays of the critical paths across process-voltage-temperature variations. The sensitized critical paths may thus be utilized for efficient implementation of the ADVC technology.

Thus, it is paramount that all the critical paths of the IC 102 are accurately sensitized for the optimal operation thereof.

In the present disclosure, the critical logic circuit 104 is shown to include two critical paths, namely, a first critical path 106 and a second critical path 108. In an embodiment, the first and second critical paths 106 and 108 are sensitized simultaneously. In another embodiment, the first and second critical paths 106 and 108 are sensitized sequentially. In the present disclosure, the sensitization of the first critical path 106 is explained in detail. The second critical path 108 may be sensitized in a manner similar to that of the first critical path 106, without deviating from the scope of the present disclosure.

The IC 102 may further include a sensitizing circuit 110 that may be configured to facilitate the sensitization of a critical path (*e.g.,* the first critical path 106) of the critical logic circuit 104. The sensitizing circuit 110 may include an interface circuit 112, a control circuit 114, and a plurality of scan chains 116. In the present disclosure, the plurality of scan chains 116 may be utilized for critical path sensitization.

### Test circuit 118:

As described above, the IC 102 may need to be switched to the testing mode to enable the testing of the critical paths. To enable such an operation, the testing environment 100 may further include a test circuit 118. The test circuit 118 may be coupled to the IC 102 (*e.g.,* the interface circuit 112). The test circuit 118 may include suitable circuitry that may be configured to perform one or more operations. For example, the test circuit 118 may be configured to determine a critical path (*e.g.,* the first critical path 106) for sensitization. Further, the test circuit 118 may be configured to identify, from the plurality of scan chains 116, one or more scan chains that are required for the sensitization of the first critical path 106. In an embodiment, the plurality of scan chains 116 may include first through fourth scan chains 116a-116d, and the test circuit 118 may identify that the first and second scan chains 116a and 116b are required for the sensitization of the first critical path 106.

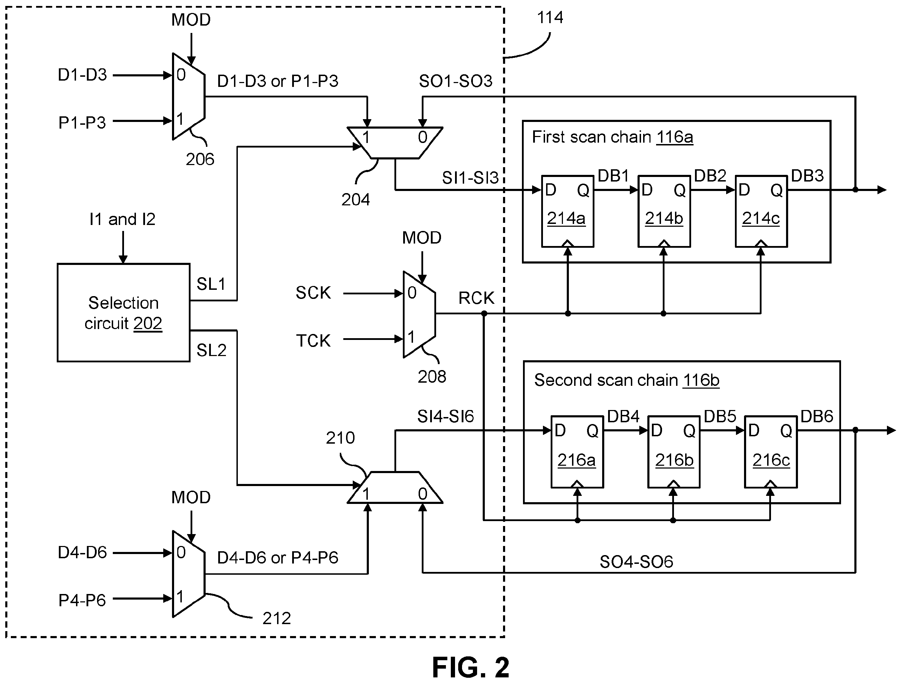

Each of the first and second scan chains 116a and 116b may include one or more scan flip-flops (shown later in FIG. 2) that facilitate the sensitization of the first critical path 106. Output terminals of such scan flip-flops may be coupled, directly or indirectly, to some input terminals of the elements of the first critical path 106. These input terminals are required to be maintained at predetermined logic levels to ensure that the input signal traverses exclusively through the elements of the first critical path 106. Output bits of such scan flip-flops may be utilized to ensure that the input terminals are maintained at the predetermined logic levels. The output terminal of each scan flip-flop may be required to output a logic high bit or a logic low bit to enable the aforementioned operation. In such a scenario, the test circuit 118 may be further configured to determine whether the first critical path 106 is functionally valid. For example, if for sensitization of a critical path, an output bit of a scan flip-flop is required to be logic high and low simultaneously, the corresponding critical path is functionally invalid and is not required to be sensitized. Such a determination ensures that only functionally valid critical paths are sensitized, thereby reducing the stress on the voltage-frequency relationship of the IC 102. For the sake of ongoing discussion, it is assumed that the first critical path 106 is functionally valid.

Thus, to sensitize the first critical path 106, specific scan flip-flops of the first and second scan chains 116a and 116b are required to be configured to specific logic states. To enable such an operation, the test circuit 118 may be further configured to generate a first configuration dataset C1 and a second configuration dataset C2 for the first and second scan chains 116a and 116b, respectively. The first configuration dataset C1 may include a first scan chain identifier (shown later in FIG. 2) of the first scan chain 116a and a first test pattern TP1 required to configure the first scan chain 116a. Similarly, the second configuration dataset C2 may include a second scan chain identifier (shown later in FIG. 2) of the second scan chain 116b and a second test pattern TP2 required to configure the second scan chain 116b. In an embodiment, the first and second test patterns TP1 and TP2 may correspond to single load patterns.

The test circuit 118 may be further configured to generate a mode signal MOD. The mode signal MOD is indicative of an activation of critical path sensitization in the IC 102. In an embodiment, the mode signal MOD is asserted (*e.g.,* is at a logic high state) when a critical path (*e.g.,* the first critical path 106) is to be sensitized. Conversely, the mode signal MOD is de-asserted (*e.g.,* is at a logic low state) when the critical path sensitization is not required. In such a scenario, a default testing operation (*e.g.,* an at-speed testing operation) may be executed. The test circuit 118 may be further configured to generate a test clock signal TCK to enable synchronization during critical path sensitization.

The test circuit 118 may be further configured to provide the mode signal MOD, the test clock signal TCK, the first configuration dataset C1, and the second configuration dataset C2 to the interface circuit 112. In an embodiment, the test circuit 118 corresponds to an automatic test pattern generator (ATPG) tool. Although not shown, the test circuit 118 may include various components for facilitating various operations thereof. For example, the test circuit 118 may include a pattern generator to generate the first and second test patterns TP1 and TP2, a test clock generator to generate the test clock signal TCK, and a test control circuit to generate the mode signal MOD.

Although not shown, the test circuit 118 may be further configured to generate a scan enable signal to activate the testing mode of the IC 102.

### Interface circuit 112:

The interface circuit 112 may be coupled to the test circuit 118 and the control circuit 114. The interface circuit 112 may include suitable circuitry that may be configured to perform one or more operations. For example, the interface circuit 112 may be configured to facilitate an IC interface (*e.g.,* a plurality of general-purpose input-output (GPIO) pins) for the test circuit 118 that is external to the IC 102. Thus, the interface circuit 112 may be configured to receive, from the test circuit 118, the first and second configuration datasets C1 and C2, the test clock signal TCK, and the mode signal MOD. In an embodiment, the interface circuit 112 corresponds to a joint test action group (JTAG) interface. The JTAG interface is an industry-standard interface primarily used for testing, debugging, and programming ICs. The JTAG interface provides a standardized way for the test circuit 118 to communicate with and control the IC 102. Further, the interface circuit 112 may be configured to provide the first and second configuration datasets C1 and C2, the test clock signal TCK, and the mode signal MOD to the control circuit 114 to enable the sensitization of the first critical path 106.

### Control circuit 114:

The control circuit 114 may be coupled to the interface circuit 112 and the plurality of scan chains 116. The control circuit 114 may be configured to receive the first and second configuration datasets C1 and C2, the test clock signal TCK, and the mode signal MOD from the interface circuit 112.

The control circuit 114 may be further configured to receive a shift clock signal SCK. The testing environment 100 may further include a shift clock generator 120 that may be external to the IC 102 and coupled to the control circuit 114. The shift clock generator 120 may be configured to generate the shift clock signal SCK to synchronize the default testing operation of the IC 102 and provide the shift clock signal SCK to the control circuit 114. The default testing operation may be executed when the mode signal MOD is at the logic low state. Examples of the shift clock generator 120 may include a crystal oscillator, a voltage-controlled crystal oscillator, a phase-locked loop clock generator, or the like.

The control circuit 114 may be further configured to receive first through fourth decompressor patterns DP1-DP4. The IC 102 may further include a decompressor 122 that may be coupled to the control circuit 114. The decompressor 122 may be configured to generate a decompressor pattern for each scan chain to configure the corresponding scan chain during the default testing operation. Thus, the decompressor 122 may generate the first through fourth decompressor patterns DP1-DP4 to configure the first through fourth scan chains 116a-116d, respectively, and provide the first through fourth decompressor patterns DP1-DP4 to the control circuit 114. In an embodiment, the decompressor 122 may receive a reference pattern (not shown) from a reference pattern generator (not shown) that may be external to the IC 102. The reference pattern may have a limited number of bits (*e.g.,* 10 to 15). The decompressor 122 may include a linear feedback shift register (LFSR) and various XOR gates that enable the implementation of a specific decompression technique on the reference pattern. Such an implementation results in the generation of decompression patterns (*e.g.,* the first through fourth decompressor patterns DP1-DP4) for configuring all the scan chains of the IC 102 (*e.g.,* the first through fourth scan chains 116a-116d).

Based on the mode signal MOD, the control circuit 114 may be further configured to determine whether the critical path sensitization is activated. If the mode signal MOD is at the logic low state, the control circuit 114 may be configured to provide the shift clock signal SCK and the first through fourth decompressor patterns DP1-DP4 to the plurality of scan chains 116 to enable the execution of the default testing operation. The first through fourth scan chains 116a-116d may be loaded with the first through fourth decompressor patterns DP1-DP4, respectively, in synchronization with the shift clock signal SCK. In an embodiment, the first through fourth decompressor patterns DP1-DP4 may be loaded in a sequential manner.

Conversely, if the mode signal MOD is at the logic high state, the control circuit 114 may determine that the sensitization of the first critical path 106 is enabled. In other words, the sensitization of the first critical path 106 is enabled based on the asserted state of the mode signal MOD. In such a scenario, the scan chain loading is controlled based on the test clock signal TCK and the first and second configuration datasets C1 and C2.

The first and second configuration datasets C1 and C2 may be received by the control circuit 114 from the test circuit 118, via the interface circuit 112, in a sequential manner. For each configuration dataset, the control circuit 114 may be further configured to identify, from the plurality of scan chains 116, a scan chain that is associated with a scan chain identifier included in the corresponding configuration dataset and load the identified scan chain with a test pattern included in the corresponding configuration dataset. For example, when the first configuration dataset C1 is received, the control circuit 114 may identify, from the plurality of scan chains 116, the first scan chain 116a that is associated with the first scan chain identifier, and load the first scan chain 116a with the first test pattern TP1. Similarly, when the second configuration dataset C2 is received, the control circuit 114 may identify, from the plurality of scan chains 116, the second scan chain 116b that is associated with the second scan chain identifier, and load the second scan chain 116b with the second test pattern TP2. The first and second scan chains 116a and 116b are one or more scan chains of the plurality of scan chains 116 that are coupled to the critical logic circuit 104 and are associated with the sensitization of the first critical path 106. Thus, the first and second scan chains 116a and 116b are loaded with the first and second test patterns TP1 and TP2, respectively, to sensitize the first critical path 106.

The first and second scan chains 116a and 116b are sequentially loaded with the first and second test patterns TP1 and TP2, respectively. Further, while the second test pattern TP2 is loaded in the second scan chain 116b, the first test pattern TP1 is simultaneously reloaded in the first scan chain 116a. Thus, during the sensitization of the first critical path 106, the control circuit 114 may be further configured to receive the first and second test patterns TP1 and TP2 from the first and second scan chains 116a and 116b, respectively, for reloading.

Each test pattern is loaded in a corresponding scan chain in synchronization with the test clock signal TCK. For example, the first and second test patterns TP1 and TP2 are loaded in the first and second scan chains 116a and 116b, respectively, in synchronization with the test clock signal TCK.

Thus, in the present disclosure, during the sensitization of the first critical path 106, exclusively the scan chains required for the sensitization are loaded, whereas, the loading of the remaining scan chains is avoided. Thus, the run time and the test time of the sensitization technique are significantly reduced. In some embodiments, the scan flip-flops identified for sensitization may be re-ordered to be spread across a minimum number of scan chains to further reduce the run time and test time.

### Plurality of scan chains 116:

The plurality of scan chains 116 may be coupled to the control circuit 114. Each of the plurality of scan chains 116 includes a plurality of scan flip-flops (shown later in FIG. 2) coupled in series. In an embodiment, the plurality of scan chains 116 have equal length. In other words, the number of scan flip-flops in each scan chain is equal. During the default testing operation, the plurality of scan chains 116 may be loaded with the first through fourth decompressor patterns DP1-DP4. Such loaded scan chains may be utilized for the at-speed testing of the IC 102. During the critical path sensitization, some scan chains (e.g., the first and second scan chains 116a and 116b) may be identified for the sensitization of the first critical path 106. Further, exclusively the identified scan chains may be loaded with the test patterns (*e.g.,* the first and second test patterns TP1 and TP2). While the second test pattern TP2 is loaded in the second scan chain 116b, the first test pattern TP1, received by the control circuit 114 from the first scan chain 116a, is simultaneously reloaded in the first scan chain 116a. Thus, at the end of the loading of the second scan chain 116b, the first scan chain 116a remains unchanged (*e.g.,* retains the loaded first test pattern TP1). The reloading ensures that after the relevant scan chains are loaded, all the desired scan flip-flops are configured with specific logic states.

Each scan chain, of the first and second scan chains 116a and 116b, includes at least one scan flip-flop that is coupled to the critical logic circuit 104. Further, the first and second scan chains 116a and 116b are loaded with the first and second test patterns TP1 and TP2, respectively, such that a set of scan flip-flops is loaded with a set of predetermined values DT. The set of scan flip-flops includes all scan flip-flops of the first scan chain 116a and all scan flip-flops of the second scan chain 116b that are coupled to the critical logic circuit 104 (*e.g.,* are required for the sensitization of the first critical path 106). The set of predetermined values DT may be utilized to sensitize the first critical path 106.

### Combinational circuit 124:

The IC 102 may further include a combinational circuit 124 that may be coupled to the sensitizing circuit 110 *(e.g.,* the set of scan flip-flops of the first and second scan chains 116a and 116b) and the critical logic circuit 104 *(e.g.,* the first critical path 106). The combinational circuit 124 may include suitable circuitry that may be configured to perform one or more operations. For example, the combinational circuit 124 may be configured to receive the set of predetermined values DT from the set of scan flip-flops. Based on the set of predetermined values DT, the combinational circuit 124 may be further configured to generate a sensitization dataset SD and provide the sensitization dataset SD to the critical logic circuit 104 to sensitize the first critical path 106. The combinational circuit 124 may include various logic gates, multiplexers, or the like.

The first critical path 106 is sensitized based on the sensitization dataset SD. In other words, some input terminals of the elements of the first critical path 106 are maintained at the predetermined logic levels based on the sensitization dataset SD. Further, the output signal associated with the first critical path 106 may be monitored to determine whether the delay of the first critical path 106 is within the tolerance limit. Additionally, the delay of the first critical path 106 may be utilized for executing various operations of the IC 102 *(e.g.,* the efficient implementation of the ADVC technology).

### Variations in FIG. 1:

The scope of the present disclosure is not limited to the electronic system 102 corresponding to an IC. In some embodiments, the electronic system 102 may correspond to a collection of ICs, a printed circuit board, or the like, without deviating from the scope of the present disclosure.

The scope of the present disclosure is not limited to the critical logic circuit 104 including two critical paths (*e.g.,* the first and second critical paths 106 and 108). In some embodiments, the critical logic circuit 104 may include less than or more than two critical paths, without deviating from the scope of the present disclosure. In such a scenario, each critical path may be sensitized in a similar manner as described above for the first critical path 106. In embodiments where the critical logic circuit 104 includes more than two critical paths, the critical paths may be sensitized simultaneously, sequentially, or a combination thereof.

The scope of the present disclosure is not limited to the plurality of scan chains 116 including four scan chains (*e.g.,* the first through fourth scan chains 116a-116d). In some embodiments, the plurality of scan chains 116 may include less than or more than four scan chains, without deviating from the scope of the present disclosure. In such a scenario, the decompressor 122 may generate the same number of decompressor patterns as the number of scan chains. Further, although it is described that only two scan chains (*e.g.,* the first and second scan chains 116a and 116b) are required for the sensitization of the first critical path 106, the scope of the present disclosure is not limited to it. In some embodiments, more than or less than two scan chains may be required for the sensitization of the first critical path 106, without deviating from the scope of the present disclosure. In such a scenario, the number of configuration datasets generated by the test circuit 118 is equal to the number of scan chains required for the sensitization.

The scope of the present disclosure is not limited to the plurality of scan chains 116 having equal length. In some embodiments, the plurality of scan chains 116 may have unequal length, without deviating from the scope of the present disclosure.

Although not shown, the IC 102 may include an additional interface circuit to enable receipt of the shift clock signal SCK and the reference pattern in the IC 102.

In some embodiments, the shift clock generator 120 and the reference pattern generator may be included in the test circuit 118.

Although not shown, the IC 102 may further include a compressor that may be configured to receive the output patterns of the plurality of scan chains 116 during the default testing operation and execute a compression technique on the received patterns to generate a compressed pattern. The compressed pattern may be utilized to determine whether the IC 102 has any structural faults.

Although it is described that the set of predetermined values DT is utilized by the combinational circuit 124 to generate the sensitization dataset SD for the sensitization of the first critical path 106, the scope of the present disclosure is not limited to it. In some embodiments, the set of predetermined values DT may be directly utilized for sensitizing the first critical path 106, without deviating from the scope of the present disclosure. In such a scenario, the set of scan flip-flops may be directly coupled to the critical logic circuit 104 (*e.g.,* the first critical path 106).

FIG. 2 illustrates a schematic block diagram of the control circuit 114 and the first and second scan chains 116a and 116b in accordance with an embodiment of the present disclosure. The control circuit 114 may include a selection circuit 202, a first multiplexer 204, a second multiplexer 206, a third multiplexer 208, a fourth multiplexer 210, and a fifth multiplexer 212.

As the first and second scan chains 116a and 116b are required for the sensitization of the first critical path 106, exclusively the first and second scan chains 116a and 116b are shown in FIG. 2 and the third and fourth scan chains 116c and 116d are not shown in FIG. 2.

### First and second scan chains 116a and 116b:

The first scan chain 116a may include first through third scan flip-flops 214a-214c that are coupled in series. Each of the first through third scan flip-flops 214a-214c may include an input terminal, a clock terminal, and an output terminal. The output terminal of the first scan flip-flop 214a may be coupled to the input terminal of the second scan flip-flop 214b, and the output terminal of the second scan flip-flop 214b may be coupled to the input terminal of the third scan flip-flop 214c. The output terminals of the first through third scan flip-flops 214a-214c may be configured to output first through third data bits DB1-DB3, respectively. Further, the clock terminals of the first through third scan flip-flops 214a-214c may be configured to receive a reference clock signal RCK. During the default testing operation, the reference clock signal RCK may correspond to the shift clock signal SCK, whereas during the critical path sensitization, the reference clock signal RCK may correspond to the test clock signal TCK. Thus, the first through third scan flip-flops 214a-214c are synchronized based on the shift clock signal SCK during the default testing operation and based on the test clock signal TCK during the critical path sensitization.

The second scan chain 116b may include fourth through sixth scan flip-flops 216a-216c that are similarly coupled in series as described above for the first scan chain 116a. Thus, the output terminals of the fourth through sixth scan flip-flops 216a-216c may be configured to output fourth through sixth data bits DB4-DB6, respectively. As illustrated in FIG. 2, the first and second scan chains 116a and 116b have equal length.

### Selection circuit 202:

The selection circuit 202 may be coupled to the interface circuit 112. The selection circuit 202 may include suitable circuitry that may be configured to perform one or more operations. For example, the selection circuit 202 may be configured to receive the first scan chain identifier of the first configuration dataset C1 and the second scan chain identifier of the second configuration dataset C2. The first and second scan chain identifiers are hereinafter referred to and designated as the "first and second scan chain identifiers I1 and I2". The first and second scan chain identifiers I1 and I2 may be received sequentially. Based on each scan chain identifier, the selection circuit 202 may be further configured to identify one of the plurality of scan chains 116 for the sensitization of the first critical path 106. Further, the selection circuit 202 may be configured to generate a plurality of select signals for the plurality of scan chains 116 such that a select signal associated with the identified scan chain is asserted (*e.g.,* is at the logic high state) and each remaining select signal of the plurality of select signals is de-asserted (*e.g.,* is at the logic low state), to enable loading of an associated test pattern in the identified scan chain. The plurality of select signals may include a select signal for each scan chain of the plurality of scan chains 116. Thus, the plurality of select signals may include a first select signal SL1, a second select signal SL2, a third select signal (now shown), and a fourth select signal (not shown) for the first through fourth scan chains 116a-116d, respectively.

Thus, when the first scan chain identifier I1 is received, the selection circuit 202 may identify the first scan chain 116a based on the first scan chain identifier I1 for the sensitization of the first critical path 106. Further, the first select signal SL1 is asserted, the second select signal SL2 is de-asserted, and the third and fourth select signals are de-asserted, to enable loading of the first test pattern TP1 in the first scan chain 116a. Similarly, when the second scan chain identifier I2 is received, the selection circuit 202 may identify the second scan chain 116b based on the second scan chain identifier I2 for the sensitization of the first critical path 106. Further, the second select signal SL2 transitions to the asserted state, the first select signal SL1 transitions to the de-asserted state, and the third and fourth select signals remain de-asserted, to enable loading of the second test pattern TP2 in the second scan chain 116b. In an embodiment, the selection circuit 202 may correspond to a one-hot decoder.

The control circuit 114 may include a pair of multiplexers to enable the loading of each scan chain. For example, the first and second multiplexers 204 and 206 enable the loading of the first scan chain 116a, and the fourth and fifth multiplexers 210 and 212 enable the loading of the second scan chain 116b. Additionally, the third multiplexer 208 is utilized to synchronize each scan chain of the plurality of scan chains 116.

### First and second multiplexers 204 and 206:

Each of the first and second multiplexers 204 and 206 may include first and second input terminals, a control terminal, and an output terminal. The first input terminal and the control terminal of the second multiplexer 206 may be coupled to the interface circuit 112, whereas the second input terminal of the second multiplexer 206 may be coupled to the decompressor 122. Further, the output terminal of the second multiplexer 206 may be coupled to the first input terminal of the first multiplexer 204 (*e.g.,* the second multiplexer 206 is coupled to the first multiplexer 204). The first multiplexer 204 may be further coupled to the first scan chain 116a and the selection circuit 202. For example, the second input terminal of the first multiplexer 204 may be coupled to the first scan chain 116a (*e.g.,* the output terminal of the last scan flip-flop, i.e., the third scan flip-flop 214c) and the control terminal of the first multiplexer 204 may be coupled to the selection circuit 202. Further, the output terminal of the first multiplexer 204 may be coupled to the first scan chain 116a (*e.g.,* the input terminal of the first scan flip-flop 214a).

Throughout the disclosure, the first and second input terminals of a multiplexer may correspond to the logic high terminal (*e.g.,* '1') and the logic low terminal (*e.g.,* '0')*,* respectively.

The first input terminal of the second multiplexer 206 may be configured to serially receive first through third pattern bits P1-P3 (collectively referred to as a "first plurality of pattern bits P1-P3") of the first test pattern TP1 from the interface circuit 112. Similarly, the second input terminal of second multiplexer 206 may be configured to serially receive first through third decompressor bits D1-D3 (collectively referred to as a "first plurality of decompressor bits D1-D3") of the first decompressor pattern DP1 from the decompressor 122. The control terminal of the second multiplexer 206 may be configured to receive the mode signal MOD from the interface circuit 112. Based on the asserted state and the de-asserted state of the mode signal MOD, the output terminal of the second multiplexer 206 may be configured to provide the first plurality of pattern bits P1-P3 and the first plurality of decompressor bits D1-D3 to the first input terminal of the first multiplexer 204, respectively.

Thus, during the default testing operation (*e.g.,* when the mode signal MOD is de-asserted), the first input terminal of the first multiplexer 204 may serially receive the first plurality of decompressor bits D1-D3. Conversely, during the critical path sensitization (e.g., when the mode signal MOD is asserted), the first input terminal of the first multiplexer 204 may serially receive the first plurality of pattern bits P1-P3. The second input terminal of the first multiplexer 204 may be configured to serially receive first through third scan output bits SO1-SO3 (collectively referred to as a "first plurality of scan output bits SO1-SO3") from the third scan flip-flop 214c. The first through third scan output bits SO1-SO3 may correspond to the third through first data bits DB3-DB1, respectively. The control terminal of the first multiplexer 204 may be configured to receive the first select signal SL1 associated with the first scan chain 116a from the selection circuit 202. Based on the first select signal SL1, the output terminal of the first multiplexer 204 may be configured to serially load first through third scan input bits SI1-SI3 (collectively referred to as a "first plurality of scan input bits SI1-SI3") in the first scan chain 116a (*e.g.,* the first through third scan flip-flops 214a-214c).

During the default testing operation, the mode signal MOD is de-asserted, and the first plurality of scan input bits SI1-SI3 corresponds to the first plurality of decompressor bits D1-D3. During the critical path sensitization, the first plurality of scan input bits SI1-SI3 may correspond to the first plurality of pattern bits P1-P3 or the first plurality of scan output bits SO1-SO3. For example, when the first scan chain 116a is to be loaded, the first select signal SL1 is asserted, and the first plurality of scan input bits SI1-SI3 corresponds to the first plurality of pattern bits P1-P3. Conversely, when the second scan chain 116b is to be loaded after the loading of the first scan chain 116a, the first select signal SL1 transitions to the de-asserted state, and the first plurality of scan input bits SI1-SI3 corresponds to the first plurality of scan output bits SO1-SO3. In other words, the first test pattern TP1 is reloaded in the first scan chain 116a. Thus, during the critical path sensitization, one of the first plurality of pattern bits P1-P3 and the first plurality of scan output bits SO1-SO3 is loaded in the first scan chain 116a based on the first select signal SL1.

To summarize, the first plurality of pattern bits P1-P3 is loaded in the first scan chain 116a based on the asserted state of the first select signal SL1, and based on the transition of the first select signal SL1 to the de-asserted state, the first plurality of pattern bits P1-P3 is serially output as the first plurality of scan output bits SO1-SO3 for reloading in the first scan chain 116a.

### Third multiplexer 208:

The third multiplexer 208 may include a first input terminal and a control terminal coupled to the interface circuit 112 and a second input terminal coupled to the shift clock generator 120. Further, the output terminal of the third multiplexer 208 may be coupled to the scan flip-flops of each scan chain of the plurality of scan chains 116. For example, the output terminal of the third multiplexer 208 may be coupled to the clock terminal of each scan flip-flop of the plurality of scan chains 116.

The first and second input terminals of the third multiplexer 208 may be configured to receive the test clock signal TCK and the shift clock signal SCK from the interface circuit 112 and the shift clock generator 120, respectively. Further, the control terminal of the third multiplexer 208 may be configured to receive the mode signal MOD from the interface circuit 112. Based on the asserted state and the de-asserted state of the mode signal MOD, the output terminal of the third multiplexer 208 may be configured to provide the test clock signal TCK and the shift clock signal SCK to the clock terminal of each scan flip-flop of the plurality of scan chains 116, respectively. Thus, during the default testing operation, the mode signal MOD is de-asserted, and the shift clock signal SCK is provided to the clock terminals of the first through sixth scan flip-flops 214a-214c and 216a-216c. Conversely, during the critical path sensitization, the mode signal MOD is asserted, and the test clock signal TCK is provided to the clock terminals of the first through sixth scan flip-flops 214a-214c and 216a-216c.

To summarize, during the default testing operation, the first through third multiplexers 204-208, collectively, enable the loading of the first plurality of decompressor bits D1-D3 in the first scan chain 116a in synchronization with the shift clock signal SCK. During the critical path sensitization, if the first scan chain 116a is to be loaded, the selection circuit 202 and the first through third multiplexers 204-208, collectively, enable the loading of the first plurality of pattern bits P1-P3 in the first scan chain 116a in synchronization with the test clock signal TCK. Further, during the critical path sensitization, if the first scan chain 116a is not to be loaded, the selection circuit 202 and the first through third multiplexers 204-208, collectively, enable the loading of the first plurality of scan output bits SO1-SO3 (e.g., reload the first plurality of pattern bits P1-P3) in the first scan chain 116a in synchronization with the test clock signal TCK.

### Fourth and fifth multiplexers 210 and 212:

Each of the fourth and fifth multiplexers 210 and 212 may include first and second input terminals, a control terminal, and an output terminal. The first input terminal and the control terminal of the fifth multiplexer 212 may be coupled to the interface circuit 112, whereas the second input terminal of the fifth multiplexer 212 may be coupled to the decompressor 122. Further, the output terminal of the fifth multiplexer 212 may be coupled to the first input terminal of the fourth multiplexer 210. The fourth multiplexer 210 may be further coupled to the second scan chain 116b and the selection circuit 202. For example, the second input terminal of the fourth multiplexer 210 may be coupled to the second scan chain 116b (*e.g.,* the output terminal of the sixth scan flip-flop 216c), and the control terminal of the fourth multiplexer 210 may be coupled to the selection circuit 202. Further, the output terminal of the fourth multiplexer 210 may be coupled to the second scan chain 116b (*e.g.,* the input terminal of the fourth scan flip-flop 216a).

The first input terminal of the fifth multiplexer 212 may be configured to serially receive fourth through sixth pattern bits P4-P6 (collectively referred to as a "second plurality of pattern bits P4-P6") of the second test pattern TP2 from the interface circuit 112. Similarly, the second input terminal of fifth multiplexer 212 may be configured to serially receive fourth through sixth decompressor bits D4-D6 (collectively referred to as a "second plurality of decompressor bits D4-D6") of the second decompressor pattern DP2 from the decompressor 122. The control terminal of the fifth multiplexer 212 may be configured to receive the mode signal MOD from the interface circuit 112. Based on the asserted state and the de-asserted state of the mode signal MOD, the output terminal of the fifth multiplexer 212 may be configured to provide the second plurality of pattern bits P4-P6 and the second plurality of decompressor bits D4-D6 to the first input terminal of the fourth multiplexer 210, respectively.

Thus, during the default testing operation, the first input terminal of the fourth multiplexer 210 may serially receive the second plurality of decompressor bits D4-D6. Conversely, during the critical path sensitization, the first input terminal of the fourth multiplexer 210 may serially receive the second plurality of pattern bits P4-P6. The second input terminal of the fourth multiplexer 210 may be configured to serially receive fourth through sixth scan output bits SO4-SO6 (collectively referred to as a "second plurality of scan output bits SO4-SO6") from the sixth scan flip-flop 216c. The fourth through sixth scan output bits SO4-SO6 may correspond to the sixth through fourth data bits DB6-DB4, respectively. The control terminal of the fourth multiplexer 210 may be configured to receive the second select signal SL2 associated with the second scan chain 116b from the selection circuit 202. Based on the second select signal SL2, the output terminal of the fourth multiplexer 210 may be configured to serially load fourth through sixth scan input bits SI4-SI6 (collectively referred to as a "second plurality of scan input bits SI4-SI6") in the second scan chain 116b (e.g., the fourth through sixth scan flip-flops 216a-216c).

During the default testing operation, the mode signal MOD is de-asserted, and the second plurality of scan input bits SI4-SI6 corresponds to the second plurality of decompressor bits D4-D6. During the critical path sensitization, the second plurality of scan input bits SI4-SI6 may correspond to the second plurality of pattern bits P4-P6 or the second plurality of scan output bits SO4-SO6. For example, when the second scan chain 116b is to be loaded, the second select signal SL2 is asserted, and the second plurality of scan input bits SI4-SI6 corresponds to the second plurality of pattern bits P4-P6. Conversely, when the second scan chain 116b is not to be loaded, the second select signal SL2 is de-asserted, and the second plurality of scan input bits SI4-SI6 corresponds to the second plurality of scan output bits SO4-SO6. Thus, during the critical path sensitization, one of the second plurality of pattern bits P4-P6 and the second plurality of scan output bits SO4-SO6 is loaded in the second scan chain 116b based on the second select signal SL2.

To summarize, the second plurality of pattern bits P4-P6 is loaded in the second scan chain 116b based on the asserted state of the second select signal SL2, and based on the transition of the second select signal SL2 to the de-asserted state, the second plurality of pattern bits P4-P6 is serially output as the second plurality of scan output bits SO4-SO6 for reloading in the second scan chain 116b.

Thus, during the default testing operation, the third through fifth multiplexers 208-212, collectively, enabled the loading of the second plurality of decompressor bits D4-D6 in the second scan chain 116b in synchronization with the shift clock signal SCK. During the critical path sensitization, if the second scan chain 116b is to be loaded, the selection circuit 202 and the third through fifth multiplexers 208-212, collectively, enable the loading of the second plurality of pattern bits P4-P6 in the second scan chain 116b in synchronization with the test clock signal TCK. Further, during the critical path sensitization, if the second scan chain 116b is not to be loaded, the selection circuit 202 and the third through fifth multiplexers 208-212, collectively, enable the loading of the second plurality of scan output bits SO4-SO6 (*e.g.,* reload the second plurality of pattern bits P4-P6) in the second scan chain 116b in synchronization with the test clock signal TCK.

Although FIG. 2 illustrates that the first and second scan chains 116a and 116b include three scan flip-flops each, the scope of the present disclosure is not limited to it. In some embodiments, each of the first through fourth scan chains 116a-116d may include less than or more than three scan flip-flops, without deviating from the scope of the present disclosure. Further, the number of decompressor bits, the number of pattern bits, the number of scan output bits, and the number of scan input bits may be equal to the number of scan flip-flops in each scan chain.

Although not shown, the control circuit 114 may include a pair of multiplexers (such as the first and second multiplexers 204 and 206 or the fourth and fifth multiplexers 210 and 212) for each of the third and fourth scan chains 116c and 116d.

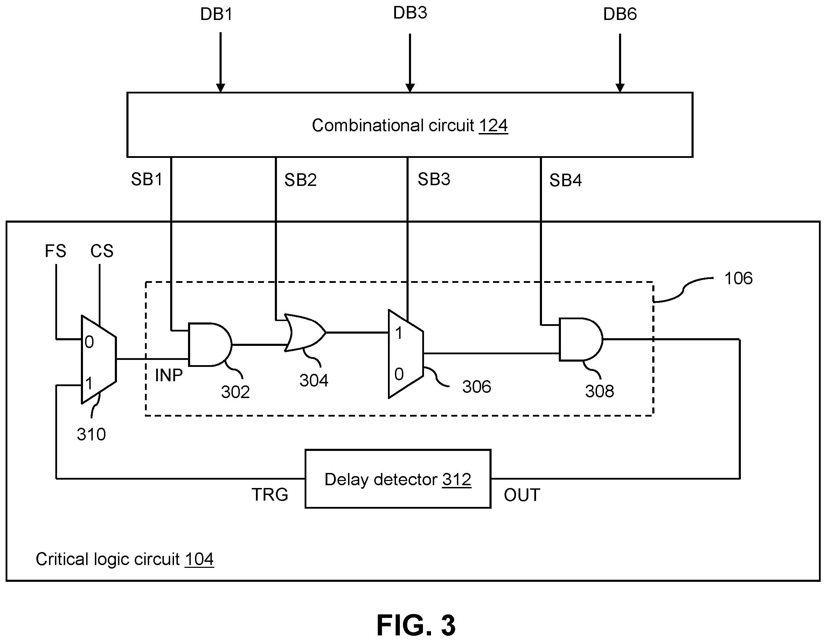

FIG. 3 illustrates a schematic circuit diagram of the critical logic circuit 104 in accordance with an embodiment of the present disclosure. The critical logic circuit 104 may include the first critical path 106. The critical logic circuit 104 (*e.g.,* the first critical path 106) may be coupled to the combinational circuit 124.

For the sake of ongoing discussion, it is assumed that the first, third, and sixth scan flip-flops 214a, 214c, and 216c are identified for the sensitization of the first critical path 106. The combinational circuit 124 may thus be coupled to the first, third, and sixth scan flip-flops 214a, 214c, and 216c. Further, the combinational circuit 124 may be configured to receive the first, third, and sixth data bits DB1, DB3, and DB6 from the first, third, and sixth scan flip-flops 214a, 214c, and 216c, respectively. The first, third, and sixth data bits DB1, DB3, and DB6 may thus constitute the set of predetermined values DT. The combinational circuit 124 may include various elements such as logic gates, multiplexers, adders, decoders, encoders, or the like.

The combinational circuit 124 may be configured to execute various logical operations on the first, third, and sixth data bits DB1, DB3, and DB6 and generate first through fourth sensitization bits SB1-SB4. The first through fourth sensitization bits SB1-SB4 may thus constitute the sensitization dataset SD. Further, the combinational circuit 124 may be configured to provide the first through fourth sensitization bits SB1-SB4 to the critical logic circuit 104 (*e.g.,* the first critical path 106) to sensitize the first critical path 106.

### Sensitization of the first critical path 106:

The first critical path 106 may include a plurality of path elements. As illustrated in FIG. 3, the plurality of path elements may include a first logic gate 302, a second logic gate 304, a sixth multiplexer 306, and a third logic gate 308. In an embodiment, the first logic gate 302 corresponds to an AND gate, the second logic gate 304 corresponds to an OR gate, and the third logic gate 308 corresponds to another AND gate.

The first through third logic gates 302, 304, and 308 may include first and second input terminals and an output terminal, whereas the sixth multiplexer 306 may include first and second input terminals, a control terminal, and an output terminal. The first input terminal of the first logic gate 302 may correspond to an input of the first critical path 106, and may be configured to receive an input signal INP. The output terminal of the first logic gate 302 may be coupled to the first input terminal of the second logic gate 304, whereas the output terminal of the second logic gate 304 may be coupled to the first input terminal of the sixth multiplexer 306. Similarly, the output terminal of the sixth multiplexer 306 may be coupled to the first input terminal of the third logic gate 308. Thus, the first logic gate 302, the second logic gate 304, the sixth multiplexer 306, and the third logic gate 308 are coupled in a chain to form a signal path. Further, the output terminal of the third logic gate 308 may correspond to an output of the first critical path 106, and may be configured to output an output signal OUT.

The second input terminal of the sixth multiplexer 306 may not be functionally active for the critical path sensitization, and hence, is not shown in FIG. 3.

The second input terminals of the first through third logic gates 302, 304, and 308 and the control terminal of the sixth multiplexer 306 may be coupled to the combinational circuit 124. The second input terminals of the first through third logic gates 302, 304, and 308 may be configured to receive the first, second, and fourth sensitization bits SB1, SB2, and SB4 from the combinational circuit 124. Similarly, the control terminal of the sixth multiplexer 306 may be configured to receive the third sensitization bit SB3 from the combinational circuit 124.

To sensitize the first critical path 106 (*e.g.,* to ensure that the input signal INP propagates through all the elements of the first critical path 106), the first sensitization bit SB1 is at the logic high state, the second sensitization bit SB2 is at the logic low state, the third sensitization bit SB3 is at the logic high state, and the fourth sensitization bit SB4 is at the logic high state. The logic high and low states of the first and second sensitization bits SB1 and SB2 ensure that the first and second logic gates 302 and 304 (*e.g.,* the AND gate and the OR gate) output the signal traversing at the other input terminals (*e.g.,* the first input terminals). Similarly, the logic high state of the third sensitization bit SB3 ensures that the sixth multiplexer 306 outputs the signal received from the second logic gate 304. Further, the logic high state of the fourth sensitization bit SB4 ensures that the third logic gate 308 (*e.g.,* the AND gate) outputs the signal received from the sixth multiplexer 306. The input signal INP may thus traverse through all the elements of the first critical path 106. The sensitization of the first critical path 106 thus results in the input signal INP propagating through each of the plurality of path elements. The first through fourth sensitization bits SB1-SB4 thus ensure that the first critical path 106 is sensitized.

### Delay determination:

The critical logic circuit 104 may further include a seventh multiplexer 310. The seventh multiplexer 310 may include first and second input terminals configured to receive a trigger signal TRG and a functional signal FS, respectively. The seventh multiplexer 310 may further include a control terminal configured to receive a control signal CS. In an embodiment, the control signal CS may be derived from the mode signal MOD. The seventh multiplexer 310 may further include an output terminal coupled to the first input terminal of the first logic gate 302. Based on the control signal CS, the seventh multiplexer 310 may output the functional signal FS or the trigger signal TRG as the input signal INP.

The control signal CS may be de-asserted (*e.g.,* at the logic low state) during the functional mode of the IC 102. Thus, during the functional mode, the functional signal FS may be output as the input signal INP. During the functional mode, if the first critical path 106 operates optimally, the delay between the output signal OUT and the functional signal FS is within the tolerance limit.

To test the optimal operation of the first critical path 106, the first critical path 106 may be sensitized, in the manner described above, and the delay of the sensitized first critical path 106 may be determined. The control signal CS may be asserted (*e.g.,* at the logic high state) to enable such a testing operation. As a result, the trigger signal TRG may be output as the input signal INP and may traverse through the sensitized first critical path 106. The trigger signal TRG may enable the determination of the delay of the first critical path 106 and whether the determined delay is within the tolerance limit.

The critical logic circuit 104 may further include a delay detector 312. The delay detector 312 may be coupled to the first input terminal of the seventh multiplexer 310 and the output terminal of the third logic gate 308. The delay detector 312 may be configured to receive the output signal OUT from the output terminal of the third logic gate 308.

The delay detector 312 may be further configured to generate the trigger signal TRG based on the output signal OUT. In an embodiment, to enable the determination of the delay of the first critical path 106, the delay detector 312 may be configured to monitor the output signal OUT and adjust the logic state of the trigger signal TRG such that the output signal OUT toggles for each clock cycle. For example, in the first critical path 106 illustrated in FIG. 3, the logic state of the output signal OUT is the same as the input signal INP (*e.g.,* the first critical path 106 acts as a buffer). Thus, the delay detector 312 may toggle the logic state of the trigger signal TRG for each clock cycle to achieve the similar result at the output signal OUT. The first critical path 106 may thus resemble a ring oscillator, with the output signal OUT resembling a clock signal. The delay detector 312 may be further configured to determine the delay of the first critical path 106 based on the frequency of the toggling output signal OUT. In addition to adjusting the logic state of the trigger signal TRG, the delay detector 312 may be further configured to adjust a delay of the trigger signal TRG. In an embodiment, the delay detector 312 may include a delay-locked-loop (DLL), and the DLL code may control the delay of the trigger signal TRG, and in turn, the input and output signals INP and OUT.

Initially, the DLL code may correspond to zero. The delay detector 312 may determine the time period of the output signal OUT for the zero value of the DLL code. The DLL code is then iteratively adjusted (*e.g.,* increased) until the delay detector 312 determines that the time period of the output signal OUT is half of the initial value (*e.g.,* when the DLL code is zero). The DLL code at such an instance is indicative of the delay of the first critical path 106. Further, the delay detector 312 may be configured to determine whether the delay of the first critical path 106 is within the tolerance limit (*e.g.,* the first critical path 106 is devoid of timing faults). The determined delay may be utilized for various operations of the IC 102 (*e.g.,* efficient implementation of the ADVC technology).

The scope of the present disclosure is not limited to the first critical path 106 including four logic elements. In some embodiments, the first critical path 106 may include multiple logic elements arranged differently, without deviating from the scope of the present disclosure. Similarly, the number of sensitization bits may be different.

The critical logic circuit 104 may include various other components that are not shown in FIG. 3 to keep the illustrations concise and clear and should not be considered a limitation of the present disclosure.

Although it is described that the first, third, and sixth scan flip-flops 214a, 214c, and 216c are identified for critical path sensitization, the scope of the present disclosure is not limited to it. In some embodiments, different combinations of scan flip-flops may be identified for the critical path sensitization, without deviating from the scope of the present disclosure.

The term "assert" is used to mean placing a signal in an active state. Some signals may be assert-high signals, whereas some signals may be assert-low signals. With assert-high signals, the assertion of a signal corresponds to the signal being in a logic high state. Conversely, with assert-low signals, the assertion of a signal corresponds to the signal being in a logic low state. In the present disclosure, all signals are assert-high signals (*e.g.,* the active state corresponds to a logic high state).

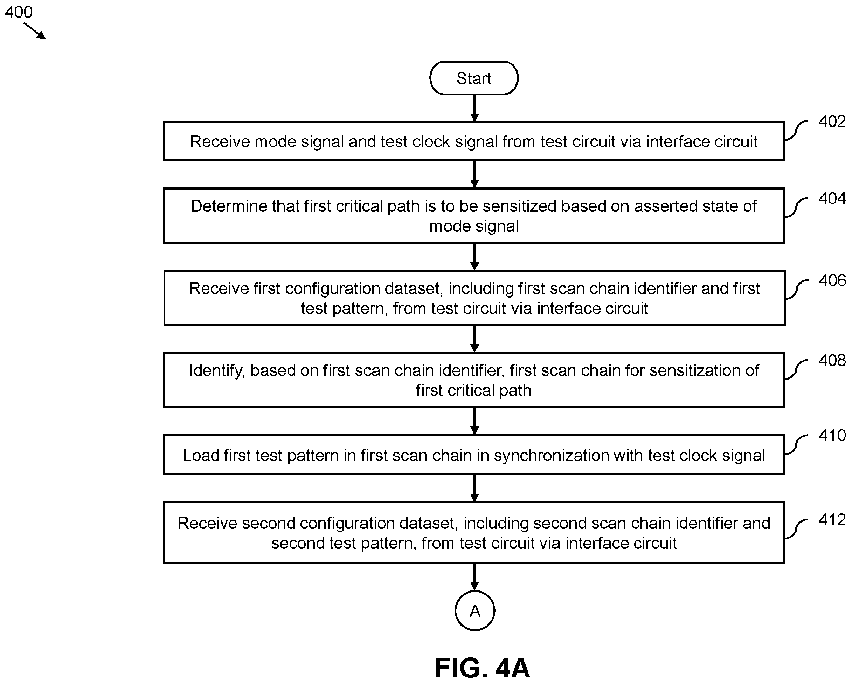

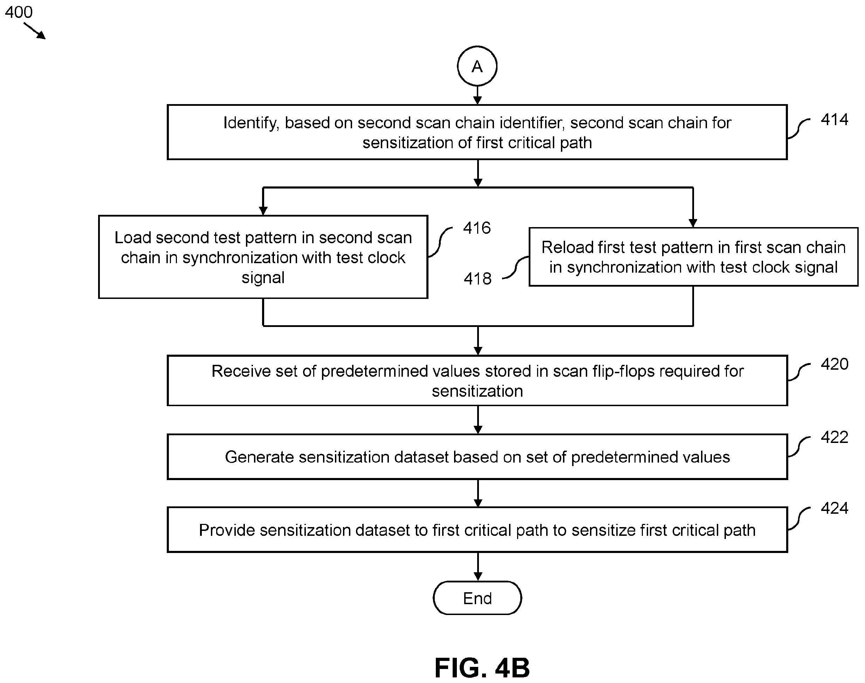

FIGS. 4A and 4B, collectively, represents a flowchart 400 that illustrates a critical path sensitization method in accordance with an embodiment of the present disclosure.

Referring to FIG. 4A, at step 402, the control circuit 114 may receive the mode signal MOD and the test clock signal TCK from the test circuit 118 via the interface circuit 112. At step 404, the control circuit 114 may determine that a critical path (*e.g.,* the first critical path 106) is to be sensitized based on the asserted state of the mode signal MOD. At step 406, the control circuit 114 may receive the first configuration dataset C1, including the first scan chain identifier I1 and the first test pattern TP1, from the test circuit 118 via the interface circuit 112. At step 408, the control circuit 114 may identify, based on the first scan chain identifier I1, the first scan chain 116a for the sensitization of the first critical path 106.

At step 410, the control circuit 114 may load the first test pattern TP1 in the first scan chain 116a in synchronization with the test clock signal TCK. That is to say that the first multiplexer 204 of the control circuit 114 may load the first plurality of pattern bits P1-P3 of the first test pattern TP1 in the first scan chain 116a based on the asserted state of the first select signal SL1. At step 412, the control circuit 114 may receive the second configuration dataset C2, including the second scan chain identifier I2 and the second test pattern TP2 from the test circuit 118 via the interface circuit 112.

Referring to FIG. 4B at step 414, the control circuit 114 may identify, based on the second scan chain identifier I2, the second scan chain 116b for the sensitization of the first critical path 106. At step 416, the control circuit 114 may load the second test pattern TP2 in the second scan chain 116b in synchronization with the test clock signal TCK. That is to say that the fourth multiplexer 210 may load the second plurality of pattern bits P4-P6 of the second test pattern TP2 in the second scan chain 116b based on the asserted state of the second select signal SL2. At step 418, the control circuit 114 may reload the first test pattern TP1 in the first scan chain 116a in synchronization with the test clock signal TCK. That is to say that the first multiplexer 204 of the control circuit 114 may load the first plurality of scan output bits SO1-SO3 (*e.g.,* reload the first plurality of pattern bits P1-P3 of the first test pattern TP1) in the first scan chain 116a based on the transition of the first select signal SL1 to the de-asserted state. Steps 416 and 418 are executed simultaneously.

At step 420, the combinational circuit 124 may receive the set of predetermined values DT (*e.g.,* the first, third, and sixth data bits DB1, DB3, and DB6) stored in the scan flip-flops required for the sensitization. At step 422, the combinational circuit 124 may generate the sensitization dataset SD (*e.g.,* the first through fourth sensitization bits SB1-SB4) based on the set of predetermined values DT. At step 424, the combinational circuit 124 may provide the sensitization dataset SD to the first critical path 106 to sensitize the first critical path 106.

Thus, in the present disclosure, the control circuit 114 and the scan chains (*e.g.,* the first and second scan chains 116a and 116b) are utilized to sensitize a critical path (*e.g.,* the first critical path 106). The scan chains are already present in the IC 102 for the structural testing thereof and the control circuit 114 includes small-sized components such as multiplexers and a decoder. Thus, the area and power consumption of the IC 102 are significantly less than that of an IC where the side pin ECO technique is implemented. Further, the sensitization technique of the present disclosure does not include the use of additional gates placed along the functional paths. As a result, the creation of additional critical paths and undesired changes in the timing requirement of the IC 102 are avoided, leading to reduced design complexity and shorter release-to-market time.

In the present disclosure, the decompressor 122 is bypassed, and the control circuit 114 directly configures the relevant scan chains to the desired values based on the configuration datasets received from the test circuit 118. This ensures complete and accurate sensitization of all critical paths. Thus, in the present disclosure, as the complete and accurate sensitization is achieved by directly loading (*e.g.,* configuring) exclusively the relevant scan chains, concatenation of all scan chains is not necessitated. Consequently, the run time and the test time of the sensitization technique of the present disclosure are less than that of some conventional techniques that require scan chain concatenation. In some embodiments, the scan flip-flops identified for sensitization may be re-ordered to be spread across a minimum number of scan chains to further reduce the run time and test time.

Additionally, in the present disclosure, during the identification of scan chains required for sensitization, the validity of each scan chain is determined. Thus, exclusively the functionally valid critical paths are sensitized, thereby reducing the stress on the voltage-frequency relationship of the IC 102, and in turn, improving the performance (*e.g.,* throughput) of the IC 102 over the lifespan. The sensitization technique of the present disclosure enables simultaneous and dynamic sensitization of all critical paths, thereby increasing the efficiency of the sensitization.

In an embodiment of the present disclosure, an electronic system is disclosed. The electronic system may include a critical logic circuit, a plurality of scan chains, and a control circuit. The critical logic circuit may include a critical path. One or more scan chains, of the plurality of scan chains, are coupled to the critical logic circuit and are associated with sensitization of the critical path. Further, the control circuit may be coupled to the plurality of scan chains. The control circuit may be configured to receive one or more configuration datasets, where each configuration dataset includes a scan chain identifier and a test pattern. For each configuration dataset of the one or more configuration datasets, the control circuit may be further configured to identify, from the plurality of scan chains, a scan chain, of the one or more scan chains, that is associated with the scan chain identifier, and load the identified scan chain with the test pattern to sensitize the critical path.

In another embodiment of the present disclosure, a sensitization method is disclosed. The sensitization method includes receiving, by a control circuit of a sensitizing circuit, one or more configuration datasets. Each configuration dataset comprises a scan chain identifier and a test pattern. The sensitization method further includes identifying, by the control circuit, one or more scan chains from a plurality of scan chains of the sensitizing circuit, based on one or more scan chain identifiers of the one or more configuration datasets, respectively. The one or more scan chains are associated with sensitization of a critical path, of a critical logic circuit. The sensitization method further includes loading, by the control circuit, the one or more scan chains with one or more test patterns of the one or more configuration datasets, respectively, to sensitize the critical path.

In some embodiments, the plurality of scan chains have equal length.

In some embodiments, the one or more scan chains are sequentially loaded with one or more test patterns of the one or more configuration datasets, respectively.

In some embodiments, the one or more scan chains may include a first scan chain and a second scan chain that are loaded with a first test pattern and a second test pattern, of the one or more test patterns, respectively. While the second test pattern is loaded in the second scan chain, the first test pattern is simultaneously reloaded in the first scan chain.

In some embodiments, the one or more configuration datasets are received in a sequential manner.

In some embodiments, the control circuit may be further configured to receive a mode signal. The sensitization of the critical path is enabled based on an asserted state of the mode signal.

In some embodiments, the control circuit may be further configured to receive a test clock signal. Each test pattern is loaded in a corresponding scan chain, of the one or more scan chains, in synchronization with the test clock signal.

In some embodiments, the control circuit may include a selection circuit that may be configured to receive one or more scan chain identifiers of the one or more configuration datasets, respectively. Based on each of the one or more scan chain identifiers, the selection circuit may be further configured to identify one of the plurality of scan chains for the sensitization of the critical path, and generate a plurality of select signals for the plurality of scan chains such that a select signal associated with the identified scan chain is asserted and each remaining select signal of the plurality of select signals is de-asserted, to enable loading of an associated test pattern in the identified scan chain.

In some embodiments, the control circuit may include a first multiplexer coupled to a first scan chain of the plurality of scan chains. The first multiplexer may include a first input terminal configured to serially receive a plurality of pattern bits of a first test pattern, a second input terminal coupled to the first scan chain, and configured to serially receive a plurality of scan output bits from the first scan chain, and a control terminal configured to receive a first select signal associated with the first scan chain. The first multiplexer may further include an output terminal configured to serially load one of a group consisting of the plurality of pattern bits and the plurality of scan output bits in the first scan chain based on the first select signal.

In some embodiments, the plurality of pattern bits is loaded in the first scan chain based on an asserted state of the first select signal. Based on a transition of the first select signal to a de-asserted state, the plurality of pattern bits is serially output as the plurality of scan output bits for reloading in the first scan chain.

In some embodiments, the first scan chain may include a plurality of scan flip-flops coupled in series. A last scan flip-flop, of the plurality of scan flip-flops, may include an output terminal that is coupled to the second input terminal of the first multiplexer.

In some embodiments, the control circuit may further include a second multiplexer that may be coupled to the first multiplexer. The second multiplexer may include a first input terminal configured to serially receive the plurality of pattern bits of the first test pattern, a second input terminal configured to serially receive a plurality of decompressor bits associated with the first scan chain, and a control terminal configured to receive a mode signal. The sensitization of the critical path is enabled based on an assertion of the mode signal. The second multiplexer may include an output terminal that is coupled to the first input terminal of the first multiplexer, and configured to provide the plurality of pattern bits and the plurality of decompressor bits to the first input terminal of the first multiplexer based on the asserted state and a de-asserted state of the mode signal, respectively.

In some embodiments, each scan chain, of the plurality of scan chains, may include a plurality of scan flip-flops coupled in series. The plurality of scan flip-flops of each scan chain is synchronized based on a test clock signal.

In some embodiments, the control circuit may further include a third multiplexer. The third multiplexer may include a first input terminal configured to receive the test clock signal, a second input terminal configured to receive a shift clock signal, and a control terminal configured to receive a mode signal. The sensitization of the critical path is enabled based on an asserted state of the mode signal. The third multiplexer may further include an output terminal that is coupled to the plurality of scan flip-flops of each scan chain, and configured to provide the test clock signal and the shift clock signal thereto based on the asserted state and a de-asserted state of the mode signal, respectively.

In some embodiments, each scan chain of the one or more scan chains comprises at least one scan flip-flop that is coupled to the critical logic circuit. The one or more scan chains are loaded with one or more test patterns of the one or more configuration datasets, respectively, such that a set of scan flip-flops, that is coupled to the critical logic circuit, is loaded with a set of predetermined values.

In some embodiments, the critical path may include one or more logic elements that are sensitized based on one or more sensitization bits, respectively. The one or more sensitization bits are derived from the set of predetermined values.

In some embodiments, the critical path may include a plurality of path elements. The sensitization of the critical path results in an input signal propagating through each of the plurality of path elements.

In some embodiments, the critical logic circuit may include a plurality of critical paths. The plurality of critical paths may be sensitized simultaneously.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the spirit and scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements.

## Claims

1. An electronic system, comprising:
a critical logic circuit comprising a critical path;
a plurality of scan chains, wherein one or more scan chains, of the plurality of scan chains, are coupled to the critical logic circuit and are associated with sensitization of the critical path; and
a control circuit that is coupled to the plurality of scan chains,
wherein the control circuit is configured to receive one or more configuration datasets, where each configuration dataset comprises a scan chain identifier and a test pattern, and
wherein for each configuration dataset of the one or more configuration datasets, the control circuit is further configured to (I ) identify, from the plurality of scan chains, a scan chain, of the one or more scan chains, that is associated with the scan chain identifier, and (ii) load the identified scan chain with the test pattern to sensitize the critical path.

2. The electronic system of claim 1, wherein the plurality of scan chains have equal length.

3. The electronic system of claim 1 or 2, wherein the one or more scan chains are sequentially loaded with one or more test patterns of the one or more configuration datasets, respectively.

4. The electronic system of claim 3, wherein the one or more scan chains comprise a first scan chain and a second scan chain that are loaded with a first test pattern and a second test pattern, of the one or more test patterns, respectively, and wherein while the second test pattern is loaded in the second scan chain, the first test pattern is simultaneously reloaded in the first scan chain.

5. The electronic system of any preceding claim, wherein the one or more configuration datasets are received in a sequential manner.

6. The electronic system of any preceding claim, wherein the control circuit is further configured to receive a mode signal, and wherein the sensitization of the critical path is enabled based on an asserted state of the mode signal.

7. The electronic system of any preceding claim, wherein the control circuit is further configured to receive a test clock signal, and wherein each test pattern, of the one or more configuration datasets, is loaded in a corresponding scan chain, of the one or more scan chains, in synchronization with the test clock signal.

8. The electronic system of any preceding claim,
wherein the control circuit comprises a selection circuit that is configured to receive one or more scan chain identifiers of the one or more configuration datasets, respectively, and
wherein based on each of the one or more scan chain identifiers, the selection circuit is further configured to (i) identify one of the plurality of scan chains for the sensitization of the critical path, and (ii) generate a plurality of select signals for the plurality of scan chains such that a select signal associated with the identified scan chain is asserted and each remaining select signal of the plurality of select signals is de-asserted, to enable loading of an associated test pattern in the identified scan chain.

9. The electronic system of any preceding claim, wherein the control circuit comprises a first multiplexer coupled to a first scan chain of the plurality of scan chains, the first multiplexer comprising:
a first input terminal configured to serially receive a plurality of pattern bits of a first test pattern;
a second input terminal that is coupled to the first scan chain, and configured to serially receive a plurality of scan output bits from the first scan chain;
a control terminal configured to receive a first select signal associated with the first scan chain; and
an output terminal configured to serially load one of a group consisting of the plurality of pattern bits and the plurality of scan output bits in the first scan chain based on the first select signal.

10. The electronic system of claim 9, wherein the plurality of pattern bits is loaded in the first scan chain based on an asserted state of the first select signal, and wherein, based on a transition of the first select signal to a de-asserted state, the plurality of pattern bits is serially output as the plurality of scan output bits for reloading in the first scan chain.

11. The electronic system of claim 9 or 10, wherein the first scan chain comprises a plurality of scan flip-flops coupled in series, and wherein a last scan flip-flop, of the plurality of scan flip-flops, comprises an output terminal that is coupled to the second input terminal of the first multiplexer.

12. The electronic system of any of claims 9 to 11, wherein the control circuit further comprises a second multiplexer that is coupled to the first multiplexer, the second multiplexer comprising:
a first input terminal configured to serially receive the plurality of pattern bits of the first test pattern;
a second input terminal configured to serially receive a plurality of decompressor bits associated with the first scan chain;
a control terminal configured to receive a mode signal, wherein the sensitization of the critical path is enabled based on an asserted state of the mode signal; and
an output terminal that is coupled to the first input terminal of the first multiplexer, and configured to provide the plurality of pattern bits and the plurality of decompressor bits to the first input terminal of the first multiplexer based on the asserted state and a de-asserted state of the mode signal, respectively.

13. The electronic system of any preceding claim, wherein each scan chain, of the plurality of scan chains, comprises a plurality of scan flip-flops coupled in series, and wherein the plurality of scan flip-flops of each scan chain is synchronized based on a test clock signal.

14. The electronic system of claim 13, wherein the control circuit further comprises a third multiplexer that comprises:
a first input terminal configured to receive the test clock signal;
a second input terminal configured to receive a shift clock signal;
a control terminal configured to receive a mode signal, wherein the sensitization of the critical path is enabled based on an asserted state of the mode signal; and
an output terminal that is coupled to the plurality of scan flip-flops of each scan chain, and configured to provide the test clock signal and the shift clock signal thereto based on the asserted state and a de-asserted state of the mode signal, respectively.

15. The electronic system of any preceding claim, wherein the critical path comprises a plurality of path elements, and wherein the sensitization of the critical path results in an input signal propagating through each of the plurality of path elements.
